# EUROPEAN PATENT APPLICATION

(11) **EP 4 704 143 A1**
(43) Date of publication of application: **04.03.2026**
(21) Application number: 24198162.0
(22) Date of filing: 03.09.2024
(51) Int. Cl.: H01L 21/66, H01L 23/00

(54) **METHOD AND APPARATUS FOR MONITORING SUBSTRATE BONDING**

(71) Applicant: ASML Netherlands B.V., 5500 AH Veldhoven (NL)
(72) Inventor: BUIJS, Robin, Daniel, 5500 AH Veldhoven (NL); BROERS, Sander, Christiaan, 5500 AH Veldhoven (NL); DE JAGER, Pieter, Willem, Herman, 5500 AH Veldhoven (NL)
(74) Representative: ASML Netherlands B.V.

(57) **Abstract**

There is provided a substrate bonding apparatus comprising: a donor substrate support; an acceptor substrate support, an optical metrology sensor configured to measure a complex field of radiation propagating through a donor substrate and/or acceptor substrate to be bonded, said complex field of radiation the result of scattering and/or reflection of illumination radiation by a target structure comprised on the donor substrate and/or the acceptor substrate; and a controller configured to; correct the measured complex field for optical aberrations; and monitor a bonding parameter of interest based on a corrected complex field.

## Description

### FIELD OF THE INVENTION

The present invention relates to a method and apparatus for monitoring bonding of two or more substrates, in particular methods and apparatus for improving said monitoring.

### BACKGROUND OF THE INVENTION

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740Aand WO2013178422A1. These targets can be smaller than the illumination spot and may be surrounded by product structures on a wafer. Multiple gratings can be measured in one image, using a composite grating target. The contents of all these applications are also incorporated herein by reference.

Process control methods are used in the manufacture of integrated devices to monitor and control the processes of application of a pattern on a substrate or measurement of such a pattern. Such process control techniques are typically performed to obtain corrections for control of the process. Subsequently, it is sometimes required (for certain devices) to bond substrates together. Bonding processes include die-to-die, die-to-wafer and wafer-to-wafer. Wafer-to-wafer bonding, where whole wafers are permanently bonded together prior to dicing, has the potential of providing a high accuracy and high throughput bonding solution.
Die and/or wafer bonding are non-trivial processes, in which the dynamics of the bonding agent are crucial. Rapid feedback on the bonding process is vital to a high-performance, high-volume production tool. Thus, it is desirable to have improved methods of monitoring a bonding process.

### SUMMARY OF INVENTION

In an aspect there is provided a substrate bonding apparatus comprising: a donor substrate support; an acceptor substrate support, an optical metrology sensor configured to measure a complex field of radiation propagating through a donor substrate and/or acceptor substrate to be bonded, said complex field of radiation the result of scattering and/or reflection of illumination radiation by a target structure comprised on the donor substrate and/or the acceptor substrate; and a controller configured to; correct the measured complex field for optical aberrations; and monitor a bonding parameter of interest based on a corrected complex field.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic representation of a metrology apparatus.
- Figure 5 depicts a schematic representation of a dark-field digital holographic microscope.
- Figure 6 depicts a schematic representation of a dark-field digital holographic microscope.
- Figure 7 depicts a device manufacturing arrangement for making bonded substrates.
- Figure 8 depicts a device manufacturing arrangement for making bonded substrates.
- Figure 9 depicts a schematic representation of a substrate bonding apparatus in accordance with some embodiments.
- Figure 10 depicts a schematic representation of a substrate bonding apparatus in accordance with some embodiments.
- Figure 11a depicts a schematic representation of a substrate in accordance with some embodiments.
- Figure 11b depicts a schematic representation of a target structure layout in accordance with some embodiments.
- Figure 11c depicts a schematic representation of a target structure layout in accordance with some embodiments.
- Figure 12 depicts a block diagram that illustrates a computer system.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

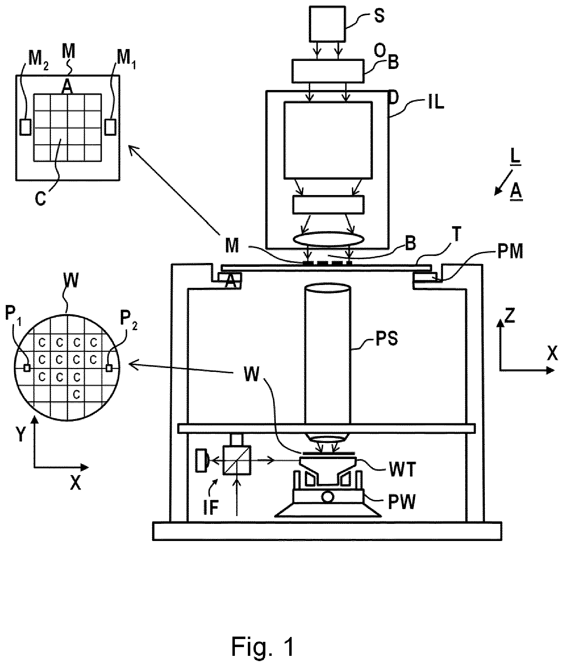

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

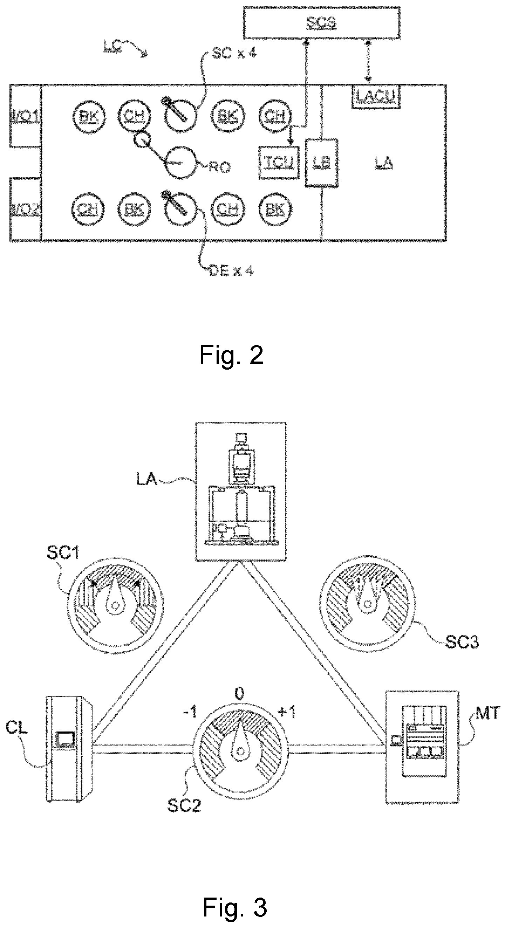

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

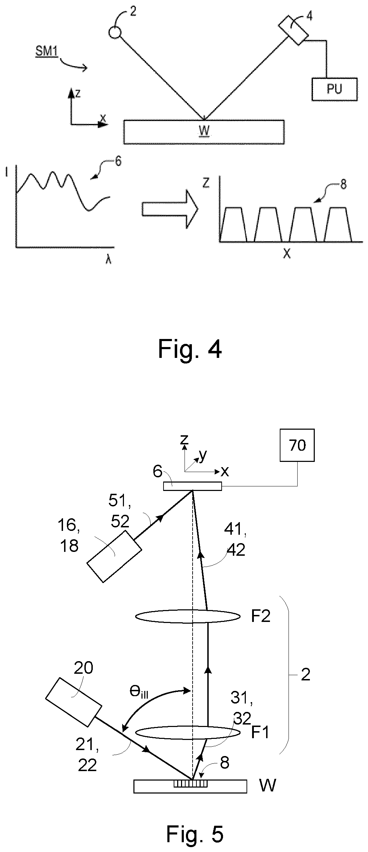

A metrology apparatus, such as a scatterometer, is depicted in Figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

### Digital Holographic Microscopy

The international patent application WO2019197117A1, incorporated herein by reference, discloses a method and metrology apparatus based on a dark field digital holographic microscope (df-DHM) to determine a characteristic, e.g., overlay, of a structure manufactured on a substrate. For the purpose of description, Figure 3 of the international patent application WO2019197117A1 is replicated in Figure 5. Figure 5 schematically illustrates the disclosed df-DHM specifically adapted for use in lithographic process metrology.

The df-DHM in Figure 5 comprises a reference optical unit 16, 18 which is used to provide additional two reference radiation beams 51, 52 (the reference radiation). Such two reference radiation beams 51, 52 are respectively paired with two corresponding portions 41, 42 of the scattered radiation beams 31, 32 (the object radiation). The two scattered-reference beam pairs are used sequentially to form two interference patterns. Coherence control is provided by way of adjusting the relative optical path-length difference (OPD) between the two scattered-reference beams within each beam pair.

The use of a sequential acquisition scheme in the example of Figure 5 allows the full NA of the objective lens to be available for both illumination and detection.

In some cases it is desirable to have a df-DHM capable of performing parallel acquisition such that a high measurement speed and a high design flexibility can be simultaneously obtained.

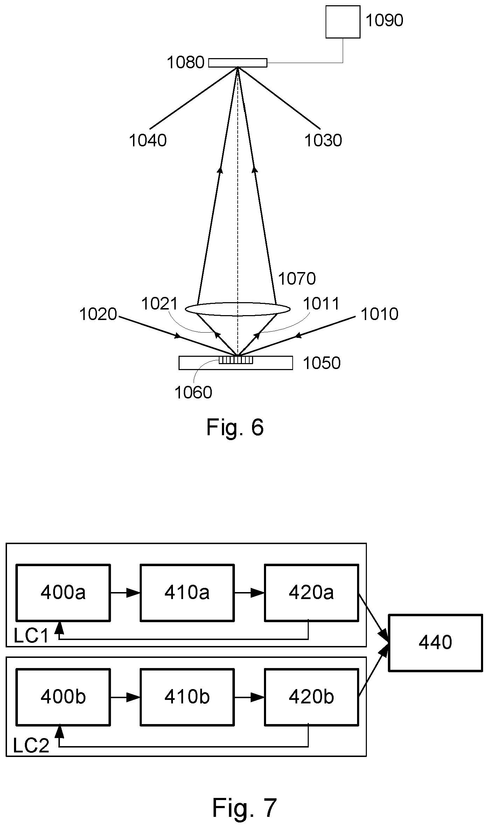

Figure 6 schematically illustrates the imaging branch of a dark field digital holographic microscope (df-DHM) 1000. A dark field digital holographic microscope (df-DHM) comprises an imaging branch and an illumination branch. In this example, a metrology target 1060 comprising a structure on a substrate 1050 is illuminated by two illumination beams of radiation, i.e., a first illumination beam of radiation 1010 and a second illumination beam of radiation 1020. In the example, such two illumination beams 1010, 1020 may simultaneously illuminate the metrology target 1060.

The first illumination beam 1010 may be incident on the metrology target 1060 at a first angle of incidence in a first direction with respect to the optical axis OA. The second illumination beam 1020 may be incident on the metrology target 1060 at a second angle of incidence in a second direction with respect to the optical axis OA. The first angle of incidence of the first illumination beam 1010 and the second angle of incidence of the second illumination beam 1020 may be substantially the same. The angle of incidence of each illumination beam may be, for example in the range of 70 degrees to 90 degrees, in the range of 50 degrees to 90 degrees, in the range of 30 degrees to 90 degrees, in the range of 10 degrees to 90 degrees. The illumination of the metrology target 1060 may result in radiation being scattered from the target. The first illumination beam 1010 may be incident on the metrology target 1060 at a first azimuthal angle, corresponding to the first direction. The second illumination beam 1020 may be incident on the metrology target 1060 at a second azimuthal angle, corresponding to the second direction. The first azimuthal angle of the first illumination beam 1010 and the second azimuthal angle of the second illumination beam 1020 may be different; e.g., opposing angles 180 degrees apart.

Depending on the structure of the metrology target 1060, the scattered radiation may comprise reflected radiation, diffracted radiation or transmitted radiation. In some examples, the metrology target may be a diffraction-based overlay target; and each illumination beam may correspond to a scattered beam comprising at least one non-zeroth diffraction order. Each scattered beam carries information of the illuminated metrology target. For example, the first illumination beam 1010 may correspond to the first scattered beam 1011 comprising the positive first diffraction order +1^{st} DF; the second illumination beam 1020 may correspond to the second scattered beam 1021 comprising the negative first diffraction order -1^{st} DF. The zeroth diffraction order and other undesired diffraction orders may either be blocked by a beam blocking element (not shown) or configured to completely fall outside the NA of the objective lens 1070. As a result, the df-DHM may be operated in a dark field mode. Note that, in some examples, one or more optical elements, e.g., a lens combination, may be used to achieve same optical effect of the objective lens 1070.

Both scattered beams 1011, 1021 may be collected by objective lens 1070 and subsequently re-focused onto an image sensor 1080. Objective lens 1070 may comprise multiple lenses, and/or df-DHM 1000 may comprise a lens system having two or more lenses, e.g., an objective lens and an imaging lens similar to the exemplary df-DHG of Figure 5, thereby defining a pupil plane of the objective lens between the two lenses and an image plane at the focus of the imaging lens. In this embodiment, a portion 1012 of the first scattered beam 1011 and a portion 1022 of the second scattered beam 1021 are simultaneously incident at a common position of the image sensor 1080. At the same time, two reference beams of radiation, i.e. a first reference beam 1030 and a second reference beam 1040, are incident on the same position of the image sensor 1080. Such four beams may be grouped into two pairs of scattered radiation and reference radiation. For example, the first scattered-reference beam pair may comprise the portion 1012 of the first scattered beam 1011 and the first reference beam 1030. Likewise, the portion 1022 of the second scattered-reference beam pair may comprise the second scattered beam 1021 and the second reference beam 1040. These two scattered-reference beam pairs may subsequently form two interference patterns (holographic images) which at least partially overlap in spatial domain.

In order to separate the two at least partially spatially overlapping interference patterns (e.g., in the spatial frequency domain), the first reference beam 1030 may have a first angle of incidence with respect to the optical axis OA and the second reference beam 1040 may have a second angle of incidence with respect to the optical axis OA; the first angle of incidence and the second angle of incidence being different. Alternatively or in addition, the first reference beam 1030 may have a first azimuthal angle with respect to the optical axis OA and the second reference beam 1040 may have a second azimuthal angle with respect to the optical axis OA; the first and second azimuthal angles being different.

In order to generate an interference pattern, the two beams of each scattered-reference beam pair should be at least partially coherent to each other, to a degree which is sufficient to form an interference pattern. Note that each scattered radiation beam may have a phase offset with respect to its corresponding illumination radiation. For example, at the image plane of the image sensor 1080, such a phase offset may comprise contributions due to the optical path-length (OPD) from the metrology target 1060 to the image sensor 1080, and by the interaction with the metrology target. It is necessary to control the coherence between the first scattered-reference beam pair and the second scattered-reference beam pair such that each beam of one pair is incoherent to any beam of the other pair. In other words, interference should only occur between the beams within the same beam pair and suppressed between different beam pairs. In such a manner, only desired interference patterns, e.g., the two interference patterns formed by respect scattered-reference beam pairs, are formed in a superimposed manner on the image sensor 1080.

### Substrate Bonding

Figure 7 shows a device manufacturing arrangement for making bonded substrates (and therefore ICs based on bonded substrates) comprising a first manufacturing lithocell LC1 and a second manufacturing lithocell LC2. Within each lithocell is a pair of lithographic processing systems 400a, 400b and first metrology systems 410a, 410b. The lithographic processing system 400a, 400b, may comprise a full patterning system. Such a system may comprise, for example, an optical lithographic apparatus or scanner such as described in respect of Figure 1, a track tool, a deposition tool, an etch tool, any other apparatus used in the patterning process, or any combination selected therefrom. The systems may also each comprise a software application 420a, 420b in communication with its respective lithographic processing system 400a, 400b and metrology system 410a, 410b, so that results, designs, data, etc. of the lithographic processing system 400a, 400b and/or the metrology apparatus 410a, 410b may be stored and analyzed by the software application 420a, 420b at the same time or different times.

Once pairs of substrates or wafers are completed from each of lithocell LC1 and lithocell LC2, they may be bonded within a bonding tool 440 to obtain a bonded wafer. Bonding in this context is wafer-to-wafer bonding where whole wafers are aligned and bonded together such that individual dies on each wafer are aligned. The concept of wafer-to-wafer bonding is known and used in many IC manufacturing processes. The bonding tool 440 may comprise a bonding alignment device for aligning the wafers together for bonding. For example, the bonding tool 440 may perform pre-align using box-in-box marks provided to wafers (e.g., one box on each wafer), with visual inspection of marks used for alignment quality/ position control. Another method uses two imaging sensors (e.g., face to face) which are first calibrated together to find their relative positions; each sensor is then used to separately align a respective wafer to be bonded.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 400a and 400b may comprise different tools or the same tools within each respective system. Similarly metrology apparatuses 410 and 410b may be the same apparatus or different apparatuses. The software application 420a, 420b may be comprised within one or both of the respective lithographic processing systems 400a, 400b and/or one or both of the first metrology systems 410a, 410b, or elsewhere.

As mentioned above, the lithographic processing system 400a, 400b may be configured to include the lithographic apparatus LA in Figure 1. The lithographic processing system 400a, 400b may be setup for executing the patterning aspect of the patterning process and optionally, may be configured to correct for deviations occurring within the lithographic processing system 400a, 400b or in one or more other processes or apparatuses in the patterning process. The lithographic processing system 400a, 400b may be able to apply a correction of an error (e.g., imaging error, focus error, dose error, etc.) by adjusting one or more modification apparatuses of the lithographic processing system 400a, 400b. That is, correction may be made by any manufacturing processing tool in the lithographic processing system 400a, 400b that can purposefully modify a patterning error. In present systems, however, these corrections (scanner corrections and other processing tool corrections) do not take into account any of the bonding processes performed by the bonding tool 440.

For example, the correction of an error can be made by adjusting one or more modification apparatuses of the lithographic apparatus, e.g., by employing the adjustment mechanism AM to correct for or apply an optical aberration, by employing the adjuster AD to correct or modify an illumination intensity distribution, by employing the positioner PM of the patterning device support structure MT and/or the positioner PW of the wafer table WT to correct or modify the position of the patterning device support structure MT and/or the wafer table WT respectively, etc. Where, for example, the lithographic processing system 400a, 400b comprises a track tool, correction of an error can be made by adjusting one or more modification apparatuses of the track tool, e.g., modifying a bake temperature of a bake tool of the track, modifying a development parameter of a development tool of the track, etc. Similarly, where, for example, the lithographic processing system 400a, 400b comprises an etch tool, correction of an error can be made by adjusting one or more modification apparatuses of the etch tool, e.g., modifying an etch parameter, such as etchant type, etchant rate, etc. Similarly, where, for example, the lithographic processing system 400a, 400b comprises a planarization tool, correction of an error can be made by adjusting one or more modification apparatuses of the planarization tool, e.g., modifying a planarization parameter. Similarly, where, for example, the lithographic processing system 400a, 400b comprises a deposition tool, correction of an error can be made by adjusting one or more modification apparatuses of the deposition tool, e.g., modifying a deposition parameter.

One or more modification apparatuses of the lithographic processing system 400a, 400b may be able to apply up to third order polynomial correction of errors (e.g., imaging error, focus error, dose error, etc.).

The metrology apparatus 410a, 410b may be configured to obtain measurements related to wafers printed with patterns by the lithographic processing system 400a, 400b. The metrology apparatus 410a, 410b may be configured to measure or determine one or more parameters (e.g., overlay error, dose, focus, CD, etc.) of the patterns printed by the lithographic processing system 400a, 400b. The metrology apparatus 410a, 410b may be a diffraction-based overlay metrology tool that can measure, e.g., overlay, critical dimension and/or other parameters. The metrology apparatus 410a, 410b may be an alignment apparatus used to measure relative position between two objects, such as between a patterning device and a wafer. The metrology apparatus 410a, 410b may be a level sensor to measure a position of a surface, e.g., a height and/or rotational position of a wafer surface. The metrology apparatus 410a, 410b may be a plurality of metrology apparatuses including any combination of these devices.

The metrology apparatus 410a, 410b may measure and/or determine one or more values of one or more parameters (e.g., overlay error, CD, focus, dose, etc.) associated with an error in the patterning process. After the metrology apparatus 410a, 410b finishes the measurement or determination, the software application 420a, 420b creates modification information based on the measurement data (e.g., overlay error, CD, focus, dose, etc.). The software application 420a, 420b may evaluate the one or more values of the one or more parameters to determine if they are within a tolerance range. If not, the software application 420a, 420b determines modification information to correct an error reflected by the out of tolerance one or more values of the one or more parameters. The software application 420a, 420b may use one or more mathematical models to determine error correctable by one or more modification apparatuses of the lithographic processing system 400a, 400b and to provide information for one or more parameters (e.g. modification information) of the one or more modification apparatuses of the lithographic processing system 400a, 400b, which one or more parameters enable configuration of the one or more modification apparatuses of the lithographic processing system 400a, 400b to correct (e.g., eliminate or reduce to within a tolerance range) the error. One or more of the mathematical models may define a set of basis functions that fit the data once parameterized. The one or more mathematical models may comprise a model configured to simulate correctable error for the lithographic processing system 400a, 400b. The model may specify a range of modifications that one or more of the modification apparatuses of the lithographic processing system 400a, 400b can make and determines correctable error within the range. That is, the range may specify an upper limit, a lower limit, and/or both on the amount of modifications that a particular modification apparatus of the lithographic processing system 400a, 400b can make.

A number of methods will now be described to improve upon the manufacturing techniques which use wafer-to-wafer bonding of two or more wafers together. The methods comprise the following:
- Overlay feedforward correction of a bonding fingerprint induced by wafer bonding-process;
- Co-optimization of correction capabilities of scanner and wafer bonder control capabilities;
- Application of reference scanner monitoring wafer to enable grid matching of to-be-bonded wafers;

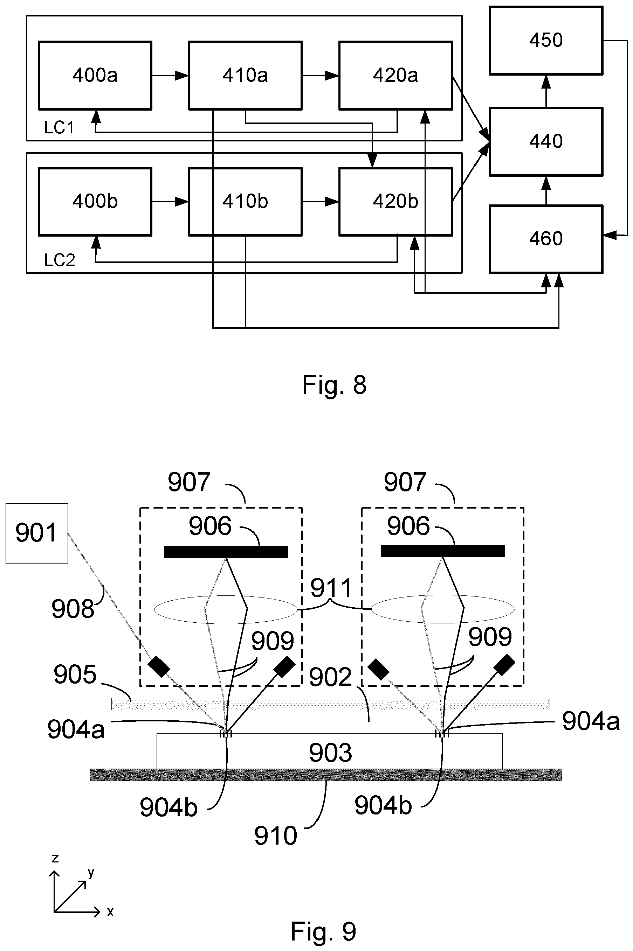

Figure 8 is a flow diagram which illustrates examples of these concepts in a single flow. However, it should be appreciated that all these concepts can be implemented individually, and/or a method disclosed herein may comprise any two or more in any combination. Each concept will now be described individually. The flow diagram of Figure 8 is based upon that of Figure 7, and the same elements have the same labels and therefore will not be necessarily described further. As represented in Figure 8, the bonding apparatus 440 may have an associated bonding metrology tool 450 and bonding software application 460. As before, the bonding metrology tool 450 may be separate to the other metrology tools in the Figure, or it may be that the same metrology tool is represented by any two or all three of metrology tools 450, 410a, 410b. Similarly, the software application 460 may be the same (or run on the same apparatus) as one or both of software applications 420a, 420b, and may be run on any of the apparatuses represented in the Figure, and/or one or more separate processing apparatuses (not shown). Also note that the description below describes the bonding process as that bonding two wafers. However, the concepts are equally applicable to bonding of more than two wafers, and as such any reference to terms such as "wafer pair" is to be understood to encompass sets of wafers greater than 2, which are to be bonded together.

As with Figure 7, lithocell LC1 and lithocell LC2 may be the same lithocell, different lithocells but comprising one or more shared tools and elements, or be completely different lithocells having completely different sets of apparatuses and tools, possibly even at different sites or fabs.

### Overlay Feedforward Correction of a Bonding Fingerprint Induced by Wafer Bonding-Process

In this concept, it is proposed to measure the across wafer parameter (e.g., overlay) fingerprint after bonding, and using this fingerprint as an input for determining a correction or optimization for the bonding process for bonding of subsequent wafers. For example, after bonding of first and second wafers W1, W2, the fingerprint may be measured by metrology tool 450 and a correction or bonding optimization determined by software application 460 for bonding third and fourth wafers W3 and W4. The correction may be determined based also on the individual fingerprints of each wafer (e.g., as measured by metrology tools 410a, 410b), such that software application deduces the bonding tool fingerprint contribution from the final bonded fingerprint and the two pre-bonding wafer fingerprints. The software application 460 can then actively actuate (e.g., via a correction and/or optimization) the bonding tool 440 to optimize overlay for bonding the next wafer pair. Therefore, this concept may be represented in Figure 8, by the loop of elements 440, 450, 460 and the feedforward of data from metrology devices 410a, 410b to software application 460.

In an example, this concept may be implemented within and by an advanced process control (APC) control loop. In an example, the feedforward may be more comprehensive (e.g. via APC controller or otherwise) by taking a larger set of historic overlay data (pre-bonding and post-bonding fingerprints) into account; e.g., to prevent unstable control (for example, where the fingerprint data for an immediately preceding wafer pair is non-representative of the process generally).

### Co-optimization of Correction Capabilities of Scanner and Wafer Bonder Control Capabilities

Based on knowledge of the bonding tool fingerprint (e.g., using methods described above) co-optimized corrections for the bonding tool fingerprint and one or both of the scanner fingerprints can be determined. The co-optimization may therefore determine co-optimized corrections for one or both exposure processes for each wafer pair to be bonded and for the bonding process, which together minimize overlay in the final bonded wafer. The co-optimization may also include corrections for other tools, such as an etching tool (which also induces its own fingerprint contribution). It can be appreciated, for example, that such a co-optimization method may actually worsen overlay (or even dies-in-spec) for one or both of the unbonded wafers, but in a manner which minimizes overlay across the bonded wafer and/or maximizes dies-in spec of the bonded wafer. Any co-optimization strategy may be used, including a die-in-spec co-optimization, a max-abs optimization, a least-squares co-optimization or any other suitable optimization. Co-optimization concepts are described, for example, in US2018/0252998 and WO2019/110261 both of which are incorporated herein by reference. Any of the co-optimization concepts described herein, but extended to the bonding process is envisaged in this concept.

For example, the co-optimization may comprise controlling the bonding tool and one or both scanner fingerprints such that the scanner corrections pre-correct for the bonding tool contribution to the overall bonded wafer overlay fingerprint. For example, such an optimization may comprise finding scanner and/or bonding tool (and/or etch tool or other tool) corrections which minimize the difference between the second wafer (pre-bonding) fingerprint and the sum of the first wafer (pre-bonding) fingerprint and the bonding tool fingerprint (for a to-be-bonded wafer pair of said first wafer and second wafer). The co-optimization may also include co-optimizing a patterning device or reticle pattern (e.g., via a reticle patterning apparatus) used for patterning the first and/or second wafer.

Such a co-optimization may be based on the correction capabilities of the relevant tools (e.g., scanners, bonding tool and/or etch tool), so as to distribute the correction across these tools to achieve lowest non-correctable error (NCE) for the parameter of interest (e.g., overlay); e.g., using a pattern fidelity control (PFC) type approach. This distribution between scanner and bonder (and possible other tool) correction capabilities can be based, not only on the type of correction capability (e.g., per spatial frequency, order, field), but also on the range of this correction capability. By way of specific example, by adding an offset to the scanner actuation, the resulting fingerprint can be brought closer to the center of the correction range of the bonding tool (or *vice versa*). Such concepts are described, for example in the aforementioned US2018/0252998.

In such an example, the co-optimization may comprise (e.g., using one or more mathematical models) determining an error correctable by one or more apparatuses of the lithographic processing systems 400a, 400b and/or the bonding tool 440, and adding an offset (e.g., deliberate error) to one of the processes performed by one of these apparatuses (or to the reticle pattern itself). For example, the offset may result in a transformation of a non-correctable error by an apparatus of the lithographic processing systems 400a, 400b or bonding tool 440 to a correctable error by one or more other apparatuses of the lithographic processing systems 400a, 400b, the bonding tool 440 and/or the reticle pattern. As an example of such transformation, an error having an uncorrectable spatial resolution for a particular apparatus of one or both lithographic processing systems 400a, 400b and/or bonding tool 440 can be enabled for correction by adding further error such that the total error has a spatial resolution correctable by the apparatus of one or both lithographic processing systems 400a, 400b and/or bonding tool 440. In an example, the added error may be divided among a plurality of the relevant apparatuses and/or the reticle pattern (e.g., via a reticle modification tool).

The co-optimization may further comprise determining a control recipe for one or both of the first lithographic processing system 400a and lithographic processing system 400b from a first control grid (e.g., measured using a scatterometer and/or alignment sensor) associated with the first lithographic processing system 400a and a second control grid (e.g., measured using a scatterometer and/or alignment sensor) associated with the second lithographic processing system 400b so as to optimize matching of first control grid and second control grid.

### Reference Scanner Monitoring Wafer to Enable Grid Matching of To-be-bonded Wafers

It is possible to match the control grids for each wafer of a wafer pair (or larger wafer set). The first and second wafers may come from different scanners 400a, 400b. These different scanners may be located within different fabs and may comprise completely different systems or platforms (e.g., one might be an EUV scanner and another may be a DUV scanner). As such, the scanners may comprise completely different control and alignment strategies and therefore may have different, incompatible, control grid definitions. While this scanner grid difference may be budgeted for the overall overlay budget of the bonded wafers, its impact may be reduced or minimized by using a common grid definition.

This may be achieved by using matched or copied monitor wafers such as those already described. A suitable processing module may calculate the difference (as a difference set or correction set) between a golden reference wafer and a standard monitor wafer exposed on each scanner. The respective monitor wafers plus the difference sets will be matched, so as to define a common grid which may be used as the control grid for the bonding process by bonding tool 440.

### Real-time Bonding Process Monitoring

Real-time, non-invasive inspection of a bonding process is both desirable and challenging. Die and wafer (also known as substrates) bonders process a wide variety of substrates with varying characteristics (e.g., optical). Often, donor and acceptor substrates are aligned with respect to each other by means of external position measurements and subsequently the donor and acceptor are bonded without further positional reference information. Typically, optical imaging is the real-time inspection method of choice: however, radiation propagation through substrates to be bonded introduces optical aberrations, which vary by substrate and diminish the quality of resulting images. Typically, there is some wavelength at which a substrate is transparent. For a silicon substrate, this may be around 1100 nanometre wavelength, and/or in the range of 1100 nanometres to 1600 nanometres. Thus, optics can be designed for high-quality imaging through any particular substrate. Accurate imaging through such a range of substrates using traditional optics design would require a highly complex apparatus, and any such solution would be both bulky and prohibitively expensive.

In order to overcome the afore-mentioned problems with typical optical imaging, it is proposed to use an optical metrology technique to measure a relative position of a donor substrate with respect to an acceptor substrate within a bonding tool (e.g., bonding tool 440).

Accordingly, in a first aspect there is provided a substrate bonding apparatus.

With reference to Figure 9, the substrate bonding apparatus may comprise a donor substrate support 905 and an acceptor substrate support 910. An illuminator 901 may be configured to illuminate a target structure disposed on a donor substrate 902 comprised on donor substrate support 905 and/or an acceptor substrate 903 comprised on acceptor substrate support 910. Illuminator 901 may be comprised in the substrate bonding apparatus or may be a separate stand-alone device.

The substrate bonding apparatus may comprise at least one optical detection unit 907. When the target structure is illuminated by illumination radiation from illuminator 901, said illumination radiation may be scattered and/or reflected from the target structure through the donor substrate 902 towards an optical sensor 906 comprised in optical detection unit 907. The optical sensor 906 is configured to measure the reflected and/or scattered radiation 909 and determine a complex field of the radiation.

Although the embodiment shown in Figure 9 comprises two optical detection units 907, it is envisioned that any number of optical detection units (i.e., one or more) may be employed as required by any particular use case.

Illuminator 901 may be optically coupled to optical detection unit 907 vie e.g., a delivery fibre assembly 908. It will be understood that delivery of illumination radiation may be subject to further beam conditioning (not pictured) as required by any particular use case or optical/illumination system.

Said donor substrate support 905 may comprise a carrier substrate. Said carrier substrate may be comprised of glass, silicon or any other suitable material (i.e., a material allowing transmittal of at least one measurable wavelength of radiation).

Said acceptor substrate support 910 may comprise a substrate support table. Said substrate support table may be moveable to configure a relative position of the acceptor substrate support 910 and the donor substrate support 905 in the X and Y directions (e.g., for relative positioning) and/or in the Z direction (e.g., for bonding).

Optical aberrations are induced as the scattered and/or reflected radiation 909 propagates through the donor substrate 902, donor substrate support 905, and/or a medium between the donor substrate 902 and the acceptor substrate 903.

An optical system (e.g., optical detection unit 907 and associated components) may have finite aberrations even without including the donor substrate 902 and/or acceptor substrate 903. Accordingly, the term optical aberrations herein relates to a variable part of the aberrations, i.e., aberrations that are not intrinsic to the optical system (e.g., optical detection unit 907) but to the full system including donor and/or acceptor substrates and/or and medium therebetween.

Owing to the determination of the complex field, it is possible to computationally correct for aberrations induced by the donor substrate 902, donor substrate support 905 and/or acceptor substrate 903 and/or a medium between the donor substrate 902 and the acceptor substrate 905. Correction may be performed by a controller (e.g., a processor) and the corrected complex field may be used to determine and/or monitor a bonding parameter of interest. Correction of the complex field may be based either on a calibration method and/or on a calculation method using known substrate (i.e., donor 902, acceptor 903, carrier substrate 905 and/or medium therebetween) material and thickness.

Said calibration method may comprise determining a calibration image of a calibration structure through the substrate of interest (i.e., by measuring a complex field of radiation scattered and/or reflected from the calibration structure propagating through the donor and/or acceptor substrate in accordance with aspects described herein). Said calibration structure may comprise a sub-measurement wavelength particle or hole, which may scatter as a point source, and thus reveal a point spread function (i.e., the response of an optical imaging system to a point source or point object) of the imaging system directly. The measured complex field may be corrected for optical aberrations based on the calibration image

Said calculation method may comprise using material properties and a thickness of the donor and/or substrate, depending on which side of the substrates to be bonded that the optical detector is disposed (i.e., which substrates are disposed between the optical detector and the target structure. The donor and/or acceptor substrate may be the thickest element between the optical sensor 906 and the target structure, and thus may dominate aberrations. Using the refractive index of the donor and/or acceptor substrate, it is possible to calculate the transfer function of the substrate material, e.g., using plane wave decomposition. Multiplying the transfer functions of all optical elements between the target structure and optical sensor 906, including those of sensor optics 911 comprised in optical detection unit 907 and any sections of air and/or other medium, reveals the point spread function of the imaging system. Accordingly, the point spread function may be decomposed into individual aberrations (e.g., using a Zernike decomposition) and corrected for computationally.

In some examples, said optical detection unit 907 comprises a holographic metrology apparatus such as a digital holographic microscope (DHM). Such a DHM may comprise a df-DHM as described with reference to Figure 6, or otherwise. Alternatively, the optical detection unit may comprise a scatterometery based metrology device or scatterometer, whereby the full field is determined using phase retrieval (computational imaging) such as described in WO2019068459A1 which is hereby incorporated herein by reference.

It is noted that the optical detection unit shown Figure 9 is intended to represent a generic optical detection unit and thus does not include reference beams (e.g., reference beams 1030 and 1040 of Figure 6) as would be present when the optical detection unit comprises a holographic metrology apparatus.

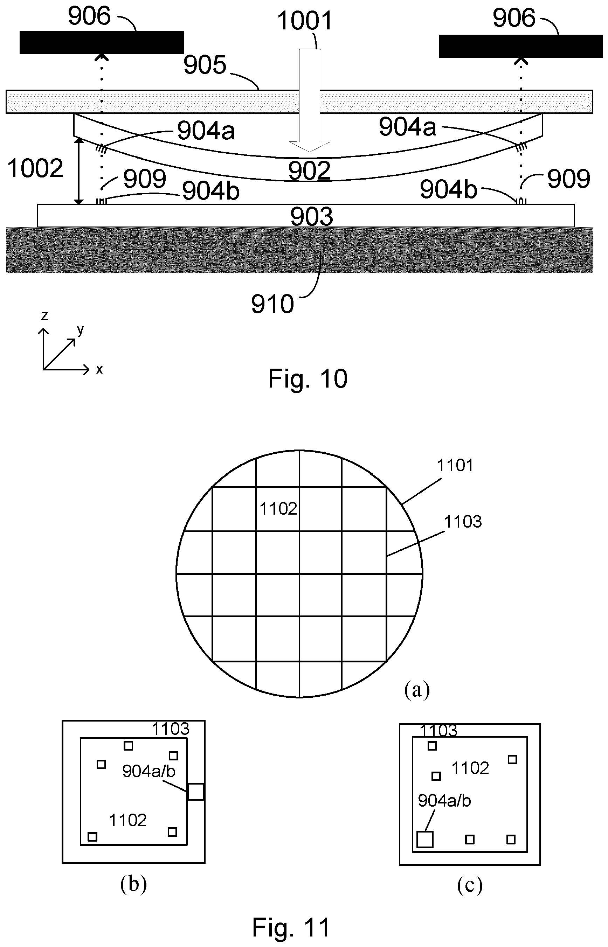

During a typical bonding process, donor and acceptor wafers are aligned to each other, and the bonding process is initiated by, for example, a short vacuum at the center of the wafers causing the wafers to make contact. The region of contact propagates towards the edge of the wafers. The edge of the contact region may be known as the bonding wavefront. Accordingly, in some examples, the bonding parameter of interest is the propagation of a bonding wavefront. Figure 10 shows a further simplified schematic of the apparatus of Figure 9. Figure 10 describes how donor substrate 902 physically distorts (e.g., the downward "bowing" of donor substrate 902) during a bonding process when pressure 1001 is applied to initiate the bonding process (e.g., through a physical bonding initiating pin, chemical initiation, laser induced forward transfer and/or the like). Accordingly, an air gap 1002 may be present between the donor substrate 902 and acceptor substrate 903 of varying magnitude during the bonding process, which may be monitored in accordance with aspects of the present disclosure. The bonding wave front propagates from the centre of the donor substrate towards an outer edge.

In some examples, the target structure is substantially located at a central region of the donor and/or acceptor substrate 902 903. This may minimise an air gap between target structures located on a donor and/or acceptor wafer 902 903. Some optical metrology techniques (e.g., digital holographic microscopy) may have a reduced resolution with air gaps greater than a threshold e.g., 30µm, 40µm, 50µm and so on. Thus, by locating the target structure substantially at a central region of the substrate, the air gap at a measurement point may be reduced, maximising the measurement resolution.

In some examples, optical detection unit 907 may be configured to move to different locations relative to the donor substrate 902 and/or acceptor substrate 903 as required by any particular use case.

In some examples the target structure may comprise a donor target structure 904a disposed on donor substrate 902 and an acceptor target structure 904b disposed on acceptor substrate 903. In such an example, the bonding parameter of interest may be an overlay (i.e., misalignment) of the donor target structure 904a and the acceptor target structure 904b. Accordingly, a movement of the donor 902 and/or acceptor 903 substrate may be proposed and/or initiated such that a relative positioning of the donor substrate 902 with respect to the acceptor substrate 903 may be adjusted based on the overlay of the donor target structure 904a and the acceptor target structure 904b.

In this way, it is possible to measure e.g., a relative X and/or Y position and/or a relative rotation rZ of a donor and/or an acceptor substrate 902 903 prior to initiating a bonding process, and make corrections to any misalignment between said donor and/or acceptor substrate 902 903 based on an overlay of the donor target structure 904a and the acceptor target structure 904b by moving e.g., the acceptor substrate support 910.

In some examples, additionally or alternatively, acquired measurements (e.g., overlay) may be applied to subsequent wafers, i.e., in a feedforward system as described with reference to Figure 8. That is, a movement of a second donor and/or second acceptor substrate may be proposed and/or initiated such that a relative positioning of the second donor substrate with respect to the second acceptor substrate may be adjusted based on the overlay of the donor target structure 904a and the acceptor target structure 904b.

Additionally or alternatively, in any or all examples the apparatus may be configured to measure the relative position of the donor and/or acceptor substrate 902 903 with respect to the optical detection unit 907.

Figure 11a is a schematic illustration of a purely exemplary substrate 1101 comprising a plurality of device areas, or dies, 1103 separated by scribe lanes 1103. Donor and/or acceptor substrates 902 903 may correspond to substrate 1101 and/or individual dies 1103.

Figures 11a and 11b are schematic illustrations of purely exemplary target structure layouts. In particular, the number of elements shown in each target structure layout and their positions is purely exemplary.

Figure 11a illustrates a typical target structure layout comprising donor and/or acceptor target structure 904a/904b disposed in scribe lane 1103. In this example, there are no target structures in device area 1102. Figure 11b illustrates another typical target structure layout wherein the scribe lane 1103 is reduced in size compared to the arrangement of Figure 11a, thereby increasing the device area 1103. In this example, donor and/or acceptor target structure 904a/904b is disposed in device area 1102.

Said target structure (e.g., comprising donor and/or acceptor target structure 904a/904b) may comprise metrology target structures such as diffraction based overlay and/or image based overlay target structures. A diffraction based overlay target structure may comprise respective periodic structures or gratings for each of the donor target structure and acceptor target structure. An image based overlay target structure may comprise complementary shapes or figures such as a box-in-box target. Said target structures may be comprised in an upper layer of a multi-layer substrate (e.g., donor and/or acceptor substrate 902 903), e.g., a first layer or a second layer. In this way, maximum diffraction efficiency may be achieved to generate an optical signal of sufficient magnitude for detection by the optical detection unit 907.

Although optical detection unit 907 is described schematically (e.g., in Figure 9 and Figure 10) as being disposed on a donor substrate side of the depicted arrangement, it will be understood that optical detection unit 907 may additionally or alternatively be disposed on an acceptor substrate side of the described arrangement. Thus, scattered and or reflected radiation may propagate through the acceptor substrate 903 and/or acceptor substrate support 910 in accordance with any and all examples described herein.

There may be multiple donor substrates, e.g., in a die-to-wafer bonding process where multiple dies (each a donor substrate) are bonded to an acceptor substrate.

In a further aspect of the present disclosure, there is provided a method of monitoring a bonding parameter of interest in a substrate bonding process, the method comprising: providing target structure on a donor and/or an acceptor substrate; illuminating the target structure; measuring a complex field of radiation scattered and/or reflected from the target structure propagation through the donor and/or acceptor wafer; correcting the measured complex field for optical aberrations to provide a corrected complex field; and monitoring the parameter of interest of the donor and/or acceptor target structure based on the corrected complex field.

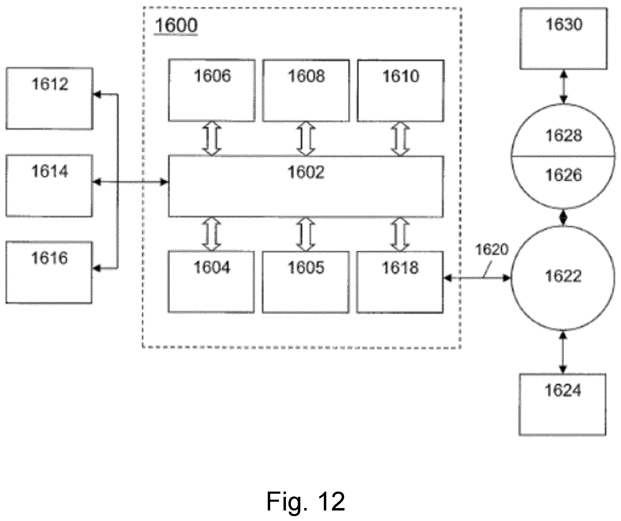

Figure 12 is a block diagram that illustrates a computer system 1600 that may assist in implementing the methods and flows disclosed herein. Computer system 1600 includes a bus 1602 or other communication mechanism for communicating information, and a processor 1604 (or multiple processors 1604 and 1605) coupled with bus 1602 for processing information. Computer system 1600 also includes a main memory 1606, such as a random access memory (RAM) or other dynamic storage device, coupled to bus 1602 for storing information and instructions to be executed by processor 1604. Main memory 1606 also may be used for storing temporary variables or other intermediate information during execution of instructions to be executed by processor 1604. Computer system 1600 further includes a read only memory (ROM) 1608 or other static storage device coupled to bus 1602 for storing static information and instructions for processor 1604. A storage device 1610, such as a magnetic disk or optical disk, is provided and coupled to bus 1602 for storing information and instructions.

Computer system 1600 may be coupled via bus 1602 to a display 1612, such as a cathode ray tube (CRT) or flat panel or touch panel display for displaying information to a computer user. An input device 1614, including alphanumeric and other keys, is coupled to bus 1602 for communicating information and command selections to processor 1604. Another type of user input device is cursor control 1616, such as a mouse, a trackball, or cursor direction keys for communicating direction information and command selections to processor 1604 and for controlling cursor movement on display 1612. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1600 in response to processor 1604 executing one or more sequences of one or more instructions contained in main memory 1606. Such instructions may be read into main memory 1606 from another computer-readable medium, such as storage device 1610. Execution of the sequences of instructions contained in main memory 1606 causes processor 1604 to perform the process steps described herein. One or more processors in a multi-processing arrangement may also be employed to execute the sequences of instructions contained in main memory 1606. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1604 for execution. Such a medium may take many forms, including but not limited to, non-volatile media, volatile media, and transmission media. Non-volatile media include, for example, optical or magnetic disks, such as storage device 1610. Volatile media include dynamic memory, such as main memory 1606. Transmission media include coaxial cables, copper wire and fiber optics, including the wires that comprise bus 1602. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1604 for execution. For example, the instructions may initially be borne on a magnetic disk of a remote computer. The remote computer can load the instructions into its dynamic memory and send the instructions over a telephone line using a modem. A modem local to computer system 1600 can receive the data on the telephone line and use an infrared transmitter to convert the data to an infrared signal. An infrared detector coupled to bus 1602 can receive the data carried in the infrared signal and place the data on bus 1602. Bus 1602 carries the data to main memory 1606, from which processor 1604 retrieves and executes the instructions. The instructions received by main memory 1606 may optionally be stored on storage device 1610 either before or after execution by processor 1604.

Computer system 1600 also preferably includes a communication interface 1618 coupled to bus 1602. Communication interface 1618 provides a two-way data communication coupling to a network link 1620 that is connected to a local network 1622. For example, communication interface 1618 may be an integrated services digital network (ISDN) card or a modem to provide a data communication connection to a corresponding type of telephone line. As another example, communication interface 1618 may be a local area network (LAN) card to provide a data communication connection to a compatible LAN. Wireless links may also be implemented. In any such implementation, communication interface 1618 sends and receives electrical, electromagnetic or optical signals that carry digital data streams representing various types of information.

Network link 1620 typically provides data communication through one or more networks to other data devices. For example, network link 1620 may provide a connection through local network 1622 to a host computer 1624 or to data equipment operated by an Internet Service Provider (ISP) 1626. ISP 1626 in turn provides data communication services through the worldwide packet data communication network, now commonly referred to as the "Internet" 1628. Local network 1622 and Internet 1628 both use electrical, electromagnetic or optical signals that carry digital data streams. The signals through the various networks and the signals on network link 1620 and through communication interface 1618, which carry the digital data to and from computer system 1600, are exemplary forms of carrier waves transporting the information.

Computer system 1600 may send messages and receive data, including program code, through the network(s), network link 1620, and communication interface 1618. In the Internet example, a server 1630 might transmit a requested code for an application program through Internet 1628, ISP 1626, local network 1622 and communication interface 1618. One such downloaded application may provide for one or more of the techniques described herein, for example. The received code may be executed by processor 1604 as it is received, and/or stored in storage device 1610, or other non-volatile storage for later execution. In this manner, computer system 1600 may obtain application code in the form of a carrier wave.

Further embodiments are disclosed in the subsequent list of numbered clauses:
1. A substrate bonding apparatus comprising:
   a donor substrate support;
   an acceptor substrate support,
   an optical metrology sensor configured to measure a complex field of radiation propagating through a donor substrate and/or acceptor substrate to be bonded, said complex field of radiation the result of scattering and/or reflection of illumination radiation by a target structure comprised on the donor substrate and/or the acceptor substrate; and
   a controller configured to;
   correct the measured complex field for optical aberrations; and
   monitor a bonding parameter of interest based on a corrected complex field.
2. The apparatus of clause 1, wherein the donor and/or acceptor substrate support is movable to configure a relative position of the donor substrate support and acceptor substrate support.
3. The apparatus of clause 2, wherein the controller is configured to control the relative position of the donor substrate support with respect to the acceptor substrate support based on the monitoring.
4. The apparatus of any previous clause, wherein the target structure comprises a donor target structure and an acceptor target structure, and wherein the bonding parameter of interest is an overlay and/or misalignment of the donor target structure and/or the acceptor target structure.
5. The apparatus of any of clauses 1 to 3, wherein the bonding parameter of interest is a bonding wavefront propagation.
6. The apparatus of any previous clause, wherein the optical aberrations are caused by the complex field of radiation propagating through the donor substrate and/or acceptor substrate.
7. The apparatus of any previous clause, wherein the optical aberrations are caused by the complex field of radiation propagating through a medium between the donor substrate and the acceptor structure.
8. The apparatus of any previous clause, wherein the donor substrate support comprises a carrier substrate.
9. The apparatus of clause 8, wherein the carrier substrate is comprised of glass or silicon.
10. The apparatus of any previous clause, wherein the optical metrology sensor is a digital holographic microscope.
11. The apparatus of any previous clause, wherein the optical metrology sensor is configured to detect radiation of wavelengths that are transparent to any of the donor substrate, acceptor substrate, carrier substrate or medium therebetween.
12. The apparatus of any previous clause, wherein the illumination radiation is of a wavelength transparent to silicon.
13. The apparatus of clause 12, wherein the wavelength is in the range of 1100 to 1600 nanometres.
14. A method of monitoring a bonding parameter of interest in a substrate bonding process, the method comprising:
   providing target structure on a donor and/or an acceptor substrate to be bonded;
   illuminating the target structure;
   measuring a complex field of radiation scattered and/or reflected from the target structure propagating through the donor and/or acceptor substrate;
   correcting the measured complex field for optical aberrations to provide a corrected complex field; and
   monitoring the bonding parameter of interest of the donor and/or acceptor target structure based on the corrected complex field.
15. The method of clause 14 further comprising configuring a relative position of the donor substrate support and acceptor substrate support based on the monitoring.
16. The method of clause 14 or clause 15, further comprising: determining a relative position of a donor target structure and an acceptor target structure comprised on the donor substrate and acceptor substrate respectively, wherein the bonding parameter of interest is an overlay of the donor target structure and the acceptor target structure.
17. The method of any of clauses 14 or 15, wherein the bonding parameter of interest is a bonding wavefront propagation.
18. The method of any of clauses 14 to 17 further comprising adjusting a relative location of a second donor and/or an acceptor substrate to be bonded based on the bonding parameter of interest.
19. A method of bonding at least two substrates comprising;
   monitoring a bonding parameter of interest in accordance with the method of any of clauses 14 to 18; and
   bonding the at least two substrates.
20. The method of clause 19 further comprising:
   determining a bonding parameter of interest of the bonded at least two substrates; and
   performing a second bonding process on at least two second substrates based on the bonding parameter of interest.
21. The method of clause 20, wherein the bonding parameter of interest is overlay of the at least two substrates.
22. The method of any of clauses 14 to 21, further comprising:
   determining a calibration image of a calibration structure comprising:
   measuring a complex field of radiation scattered and/or reflected from the calibration structure
   propagating through the donor and/or acceptor substrate, wherein the calibration structure
   comprises a sub-measurement wavelength particle or hole, and;
   correcting the measured complex field for optical aberrations based on the calibration image.
23. The method of any of clauses 14 to 21, wherein the step of correcting the measured complex field comprises:
   determining material properties and a thickness of the donor and/or acceptor substrate;
   calculating the transfer function of the donor and/or acceptor substrate based on the material properties and thickness;
   multiplying the transfer functions of all optical elements through which the radiation propagates to determine the point spread of the resulting optical system;
   decomposing the point spread function into individual aberrations, and
   correcting the measured complex field.
24. A device manufacturing arrangement comprising:
   at least one lithography cell comprising;
      at least one exposure apparatus;
      at least one metrology system;
      at least one software application in communication with the at least one exposure apparatus and metrology system; and
   the substrate bonding apparatus of any of clauses 1 to 13.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A substrate bonding apparatus comprising:
a donor substrate support;
an acceptor substrate support,
an optical metrology sensor configured to measure a complex field of radiation propagating through a donor substrate and/or acceptor substrate to be bonded, said complex field of radiation the result of scattering and/or reflection of illumination radiation by a target structure comprised on the donor substrate and/or the acceptor substrate; and
a controller configured to;
correct the measured complex field for optical aberrations; and
monitor a bonding parameter of interest based on a corrected complex field.

2. The apparatus of claim 1, wherein the donor and/or acceptor substrate support is movable to configure a relative position of the donor substrate support and acceptor substrate support.

3. The apparatus of claim 2, wherein the controller is configured to control the relative position of the donor substrate support with respect to the acceptor substrate support based on the monitoring.

4. The apparatus of any previous claim, wherein the target structure comprises a donor target structure and an acceptor target structure, and wherein the bonding parameter of interest is an overlay and/or misalignment of the donor target structure and/or the acceptor target structure.

5. The apparatus of any of claims 1 to 3, wherein the bonding parameter of interest is a bonding wavefront propagation.

6. The apparatus of any previous claim, wherein the optical aberrations are caused by the complex field of radiation propagating through the donor substrate and/or acceptor substrate.

7. The apparatus of any previous claim, wherein the optical aberrations are caused by the complex field of radiation propagating through a medium between the donor substrate and the acceptor structure.

8. The apparatus of any previous claim, wherein the optical metrology sensor is a digital holographic microscope.

9. The apparatus of any previous claim, wherein the optical metrology sensor is configured to detect radiation of wavelengths that are transparent to any of the donor substrate, acceptor substrate, carrier substrate or medium therebetween.

10. A method of monitoring a bonding parameter of interest in a substrate bonding process, the method comprising:
providing target structure on a donor and/or an acceptor substrate to be bonded;
illuminating the target structure;
measuring a complex field of radiation scattered and/or reflected from the target structure propagating through the donor and/or acceptor substrate;
correcting the measured complex field for optical aberrations to provide a corrected complex field; and
monitoring the bonding parameter of interest of the donor and/or acceptor target structure based on the corrected complex field.

11. A method of bonding at least two substrates comprising;
monitoring a bonding parameter of interest in accordance with the method of any of claim 10; and bonding the at least two substrates.

12. The method of claim 11 further comprising:
determining a bonding parameter of interest of the bonded at least two substrates; and
performing a second bonding process on at least two second substrates based on the bonding parameter of interest.

13. The method of any of claims 10 to 12, further comprising:
determining a calibration image of a calibration structure comprising:
measuring a complex field of radiation scattered and/or reflected from the calibration structure propagating through the donor and/or acceptor substrate, wherein the calibration structure comprises a sub-measurement wavelength particle or hole, and; correcting the measured complex field for optical aberrations based on the calibration image.

14. The method of any of claims 10 to 12, wherein the step of correcting the measured complex field comprises:
determining material properties and a thickness of the donor and/or acceptor substrate;
calculating the transfer function of the donor and/or acceptor substrate based on the material properties and thickness;
multiplying the transfer functions of all optical elements through which the radiation propagates to determine the point spread of the resulting optical system;
decomposing the point spread function into individual aberrations, and
correcting the measured complex field.

15. A device manufacturing arrangement comprising:
at least one lithography cell comprising;
at least one exposure apparatus;
at least one metrology system;
at least one software application in communication with the at least one exposure apparatus and metrology system; and
the substrate bonding apparatus of any of claims 1 to 9.
